# EUROPEAN PATENT SPECIFICATION

(11) **EP 3 814 811 B1**
(45) Date of publication and mention of the grant of the patent: **18.02.2026**
(21) Application number: 19829802.8
(22) Date of filing: 17.05.2019
(51) Int. Cl.: G02B 5/08, G02B 1/04, G02B 6/00

(54) **USING FLOWABLE CVD TO GAP FILL MICRO/NANO STRUCTURES FOR OPTICAL COMPONENTS**
VERWENDUNG VON FLIESSFÄHIGEM CVD ZUR SPALTFÜLLUNG VON MIKRO/NANO-STRUKTUREN FÜR OPTISCHE KOMPONENTEN
UTILISATION D'UN DÉPÔT CHIMIQUE EN PHASE VAPEUR (CVD) FLUIDE POUR REMPLIR DES MICROSTRUCTURES/NANOSTRUCTURES DESTINÉES À DES COMPOSANTS OPTIQUES

(30) Priority: 29.06.2018 US 201862692255 P
(43) Date of publication of application: 05.05.2021
(73) Proprietor: Applied Materials, Inc., Santa Clara, California 95054 (US)
(72) Inventor: FU, Jinxin, Fremont, California 94538 (US); GODET, Ludovic, Sunnyvale, California 94086 (US); MCMILLAN, Wayne, San Jose, California 95120 (US)
(74) Representative: Zimmermann & Partner Patentanwälte mbB
(86) International application number: PCT/US2019/032985
(87) International publication number: WO 2020/009748

(56) References cited:
- EP-A1- 2 717 102
- EP-A1- 3 094 160
- US-A- 5 459 807
- US-A1- 2002 135 876
- US-A1- 2015 322 286
- US-A1- 2016 126 089
- US-A1- 2017 294 339
- US-A1- 2017 335 449
- US-A1- 2018 025 907
- US-A1- 2018 122 631
- US-B1- 8 557 712

## Description

### BACKGROUND

### Field

Embodiments of the present disclosure generally relate to display devices for augmented, virtual, and mixed reality. More specifically, embodiments described herein provide a method for forming an optical component for a display device.

### Description of the Related Art

Virtual reality is generally considered to be a computer generated simulated environment in which a user has an apparent physical presence. A virtual reality experience can be generated in 3D and viewed with a head-mounted display (HMD), such as glasses or other wearable display devices that have near-eye display panels as lenses to display a virtual reality environment that replaces an actual environment.

Augmented reality enables an experience in which a user can still see through the display lenses of the glasses or other HMD device to view the surrounding environment, yet also see images of virtual objects that are generated for display and appear as part of the environment. Augmented reality can include any type of input, such as audio and haptic inputs, as well as virtual images, graphics, and video that enhances or augments the environment that the user experiences.

Both virtual reality and augmented reality display devices utilize optical components, such as waveguides or flat lens/meta surfaces, including micro or nano structures with contrasting refractive index (RI). Conventionally, a layer having a lower RI is patterned using light, e-beam, or nanoimprint lithography process, and a layer having a higher RI is formed on the patterned lower RI layer using atomic layer deposition (ALD) process. However, the film deposition rate of the ALD process is very slow.
Document US 2002/135876 A1 describes grating structures and methods of making the grating structures. A grating structure may be formed in a surface of a first piece, and a second piece may be bonded to the first piece to encapsulate the grating structure.
Document US 2015/322286 A1 describes a method of patterning sub-10nm features into inorganic films by nanoimprint lithography.
Document EP 2 171 102 A1 describes a forgery prevention structure, including a relief forming layer having a relief structure.
Document US 2017/294339 A1 describes methods for SiO₂ filling of fine recessed features. A surface of the recessed feature is coated with a metal-containing catalyst layer. A substrate at a substrate temperature of approximately 150°C or less is exposed to a process gas containing a silanol gas to deposit a conformal SiO2 film in the recessed features.
Document US 8 557 712 B1 describes a method of filling gaps on a substrate with dielectric material. A process gas comprising a silicon-containing compound and an oxidant is introduced into a reaction chamber. The silicon-containing compound and an oxidant plasma species react and condense such that an amorphous flowable organo-silicon polymer film is thereby deposited to partially fill the gaps. The flowable film is converted to a dielectric material via an in-situ treatment process.
Document US 5 459 807 A describes an optical waveguide device having an optical waveguide core disposed on a substrate. The waveguide includes an optical waveguide core in the form of a thin film of Ta₂O₅ deposited on a nonlinear optical crystalline substrate, and a dielectric loaded strip disposed on the optical waveguide core, the dielectric loaded strip being made of SiO₂ or SiO₂ doped with Ta₂O₅.
Document EP 3 094 160 A1 describes an optical substrate having shapes of projections and depressions formed on the surface thereof, and a mold to be used in manufacturing of the optical substrate. The projection-depression structure layer is laminated on the support substrate. In one embodiment, a support substrate, a projection-depression structure layer, a first electrode, an organic layer, and a second electrode are laminated in this order such that the shapes of projections and depressions formed on the surface of the projection-depression structure layer are maintained in these layers.

Accordingly, an improved method for forming optical components for virtual reality or augmented reality display devices is needed.

### SUMMARY

The invention is set out in the appended set of claims.

Embodiments of the present disclosure generally relate to a method for forming an optical component, for example, for a virtual reality or augmented reality display device. In one embodiment, a method includes forming a first layer having a pattern on a substrate, and the first layer has a first refractive index. The method further includes forming a second layer on the first layer by a flowable chemical vapor deposition process. The second layer has a second refractive index less than the first refractive index.

In another embodiment, a method includes forming a first layer having a pattern on a substrate. The first layer has a first refractive index ranging from about 1.7 to about 2.4. The method further includes forming a second layer on the first layer by a flowable chemical vapor deposition process. The second layer has a second refractive index ranging from about 1.1 to about 1.5.

In another embodiment, a method includes forming a first layer having a first pattern on a substrate. The first layer has a first refractive index and includes a metal oxide. The method further includes forming a second layer on the first layer by a flowable chemical vapor deposition process. The second layer has a second refractive index ranging from about 1.1 to about 1.5.

### BRIEF DESCRIPTION OF THE DRAWINGS

So that the manner in which the above recited features of the present disclosure can be understood in detail, a more particular description of the disclosure, briefly summarized above, may be had by reference to embodiments, some of which are illustrated in the appended drawings. It is to be noted, however, that the appended drawings illustrate only exemplary embodiments and are therefore not to be considered limiting of its scope, and may admit to other equally effective embodiments.
Figure 1 illustrates a schematic cross-sectional view of a processing chamber according to one embodiment described herein.
Figures 2A - 2D illustrate schematic cross-sectional views of an optical component during different stages according to one embodiment described herein.
Figures 3A - 3D illustrate schematic cross-sectional views of an optical component according to embodiments described herein.

To facilitate understanding, identical reference numerals have been used, where possible, to designate identical elements that are common to the figures. It is contemplated that elements and features of one embodiment may be beneficially incorporated in other embodiments without further recitation.

### DETAILED DESCRIPTION

Embodiments of the present disclosure generally relate to a method for forming an optical component, for example, for a virtual reality or augmented reality display device. In one embodiment, the method includes forming a first layer having a pattern on a substrate, and the first layer has a first refractive index. The method further includes forming a second layer on the first layer by a flowable chemical vapor deposition (FCVD) process, and the second layer has a second refractive index less than the first refractive index.

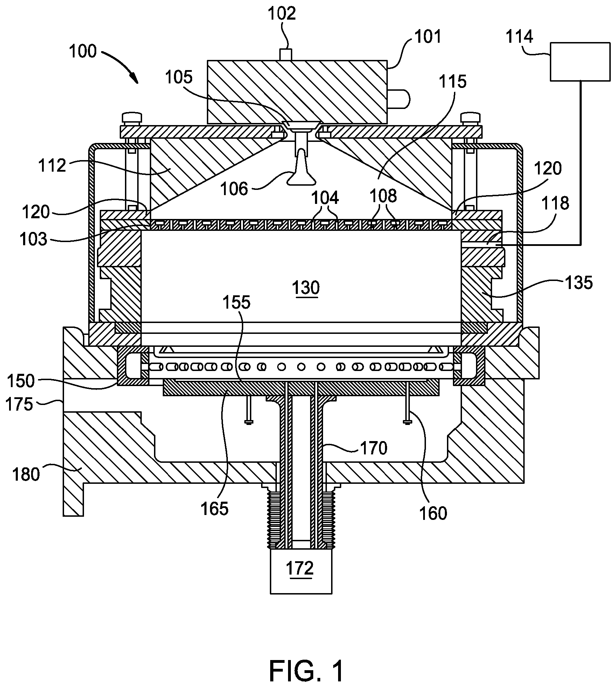

Figure 1 is a schematic cross-sectional side view of a processing chamber 100 according to one embodiment described herein. The processing chamber 100 may be a deposition chamber, such as a CVD chamber. The processing chamber 100 may be configured at least to deposit a flowable film on a substrate. The processing chamber 100 includes a lid 112 disposed over a chamber wall 135, and an insulating ring 120 disposed between the lid 112 and the chamber wall 135. A first remote plasma source (RPS) 101 is disposed on the lid 112 and precursor radicals formed in the first RPS 101 are flowed into a plasma zone 115 of the processing chamber 100 via a radical inlet assembly 105 and a baffle 106. While the first RPS 101 is illustrated as coupled to the lid 112, it is contemplated that he first RPS 101 may be spaced from the lid 112 and fluidly coupled to the lid 112 by one or more conduits. A precursor gas inlet 102 is formed on the first RPS 101 for flowing one or more precursor gases into the first RPS 101.

The processing chamber 100 further includes a dual-zone showerhead 103. The dual-zone showerhead 103 includes a first plurality of channels 104 and a second plurality of channels 108. The first plurality of channels 104 and the second plurality of channels 108 are not in fluid communication. During operation, radicals in the plasma zone 115 flow into a processing region 130 through the first plurality of channels 104 of the dual-zone showerhead 103, and one or more precursor gases flow into the processing region 130 through the second plurality of channels 108. With the dual-zone showerhead 103, premature mixing and reaction between the radicals and the precursor gases are avoided.

The processing chamber 100 includes a substrate support 165 for supporting a substrate 155 during processing. The processing region 130 is defined by the dual-zone showerhead 103 and the substrate support 165. A second RPS 114 is fluidly coupled to the processing region 130 through the chamber wall 135 of the processing chamber 100. The second RPS 114 may be coupled to an inlet 118 formed in the chamber wall 135. Since the precursor gas and precursor radicals mix and react in the processing region 130 below the dual-zone showerhead 103, deposition primarily occurs below the dual-zone showerhead 103 except some minor back diffusion. Thus, the components of the processing chamber 100 disposed below the dual-zone showerhead 103 may be cleaned after periodic processing. Cleaning refers to removing material deposited on the chamber components. The cleaning radicals are introduced into the processing region 130 at a location below (downstream of) the dual-zone showerhead 103.

The first RPS 101 is configured to excite a precursor gas, such as a silicon containing gas, an oxygen containing gas, and/or a nitrogen containing gas, to form precursor radicals that form a flowable film on the substrate 155 disposed on the substrate support 165. The second RPS 114 is configured to excite a cleaning gas, such as a fluorine containing gas, to form cleaning radicals that clean components of the processing chamber 100, such as the substrate support 165 and the chamber wall 135.

The processing chamber 100 further includes a bottom 180, a slit valve opening 175 formed in the bottom 180, and a pumping ring 150 coupled to the bottom 180. The pumping ring 150 is utilized to remove residual precursor gases and radicals from the processing chamber 100. The processing chamber 100 further includes a plurality of lift pins 160 for raising the substrate 155 from the substrate support 165 and a shaft 170 supporting the substrate support 165. The shaft 170 is coupled to a motor 172 which can rotate the shaft 170, which in turn rotates the substrate support 165 and the substrate 155 disposed on the substrate support 165. Rotating the substrate support 165 during processing or cleaning can achieve improved deposition uniformity as well as clean uniformity.

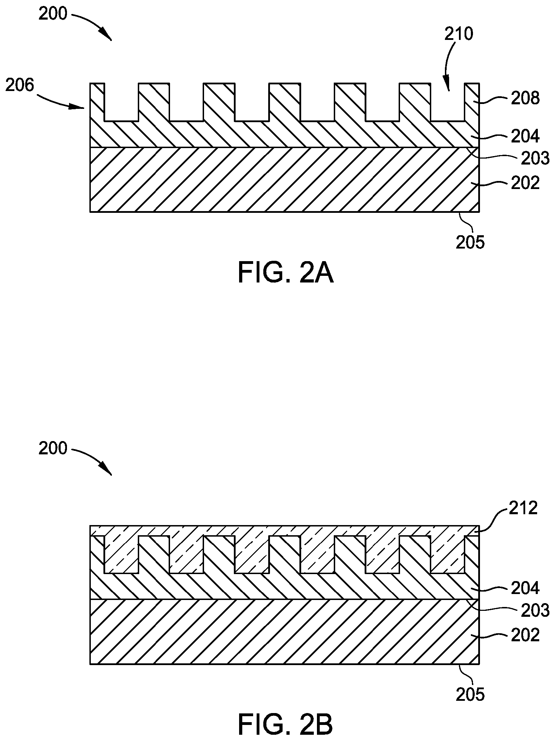

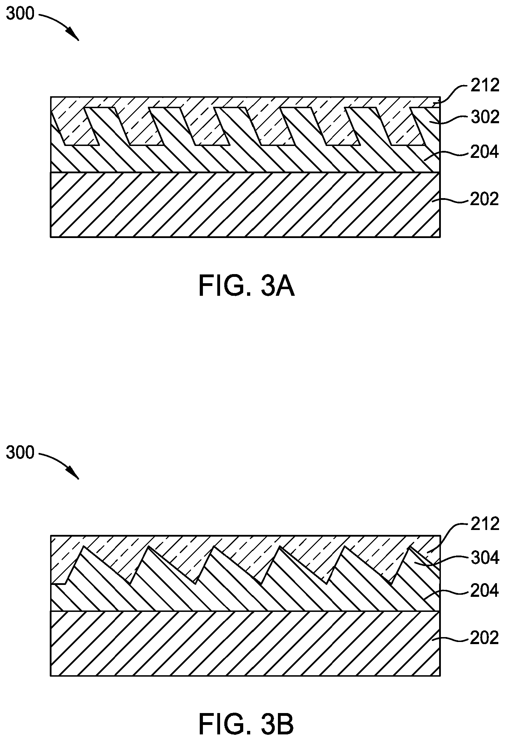

Figures 2A - 2D illustrate schematic cross-sectional views of an optical component 200 during different stages according to one embodiment described herein. As shown in Figure 2A, the optical component 200 includes a patterned first layer 204 having a first RI disposed on a first surface 203 of a substrate 202. The substrate 202 may be the substrate 155 shown in Figure 1. In one embodiment, the substrate 202 is fabricated from a visually transparent material, such as glass. The substrate 202 has a RI ranging from about 1.4 to about 2.0. The patterned first layer 204 is fabricated from a transparent material, and the first RI ranges from about 1.7 to about 2.4. In one embodiment, the RI of the substrate 202 is the same as the first RI of the patterned first layer 204. In another embodiment, the RI of the substrate 202 is different from the first RI of the patterned first layer 204. The patterned first layer 204 is fabricated from a metal oxide, such as titanium oxide (TiOₓ), tantalum oxide (TaOₓ), zirconium oxide (ZrOₓ), hafnium oxide (HfOₓ), or niobium oxide (NbOₓ). The patterned first layer 204 includes a pattern 206, and the pattern 206 includes a plurality of protrusions 208 and a plurality of gaps 210. Adjacent protrusions 208 are separated by a gap 210. As shown in Figure 2A, the protrusion 208 has a rectangular shape. The protrusion 208 may have any other suitable shape. Examples of the protrusion 208 having different shapes are shown in Figures 3A - 3D. In one embodiment, the protrusions 208 are gratings. Gratings are a plurality of parallel elongated structures that splits and diffracts light into several beams traveling in different directions. Gratings may have different shapes, such as sine, square, triangle, or sawtooth gratings. The patterned first layer 204 may be formed by any suitable method, such as e-beam lithography, nanoimprint lithography, or etching.

Next, the substrate 202 and the patterned first layer 204 formed thereon are placed into a processing chamber, such as the processing chamber 100 shown in Figure 1. A second layer 212 is formed on the patterned first layer 204 by an FCVD process. The flowable nature of the second layer 212 allows the second layer 212 to flow into small gaps, such as gaps 210. The second layer 212 has a second RI that is less than the first RI. In one embodiment, the layer 212 has a RI ranging from about 1.1 to about 1.5.

The second layer may be formed by the following process steps. An atomic oxygen precursor is generated in an RPS, such as the first RPS 101 of the processing chamber 100. The atomic oxygen may be generated by the dissociation of an oxygen containing precursor such as molecular oxygen (O₂), ozone (O₃), an nitrogen-oxygen compound (*e.g*., NO, NO₂, N₂O, etc.), a hydrogen-oxygen compound (*e.g.,* H₂O, H₂O₂, etc.), a carbon-oxygen compound (*e.g.,* CO, CO₂, etc.), as well as other oxygen containing precursors and combinations of precursors. The reactive atomic oxygen is then introduced to a processing region, such as the processing region 130 of the processing chamber 100 shown in Figure 1, where the atomic oxygen may mix for the first time with a silicon precursor, which is also introduced to the processing region. The atomic oxygen reacts with the silicon precursor (and other deposition precursors that may be present in the reaction chamber) at moderate temperatures (*e.g*., reaction temperatures less than 100° C.) and pressures (*e.g*., about 0.1 Torr to about 10 Torr; 0.5 to 6 Torr total chamber pressure, etc.) to form the second layer 212, such as a silicon dioxide layer. In one embodiment, the second layer 212 is a quartz layer.

The silicon precursor may include an organosilane compound and/or silicon compound that does not contain carbon. Silicon precursors without carbon may include silane (SiH₄), among others. Organosilane compounds may include compounds with direct Si-C bonding and/or compounds with Si-O-C bonding. Examples of organosilane silicon precursors may include dimethylsilane, trimethylsilane, tetramethylsilane, diethylsilane, tetramethylorthosilicate (TMOS), tetraethylorthosilicate (TEOS), octamethyltrisiloxane (OMTS), octamethylcyclotetrasiloxane (OMCTS), tetramethyldimethyldimethoxydisilane, tetramethylcyclotetrasiloxane (TOMCATS), DMDMOS, DEMS, methyl triethoxysilane (MTES), phenyldimethylsilane, and phenylsilane, among others.

The atomic oxygen and silicon precursors are not mixed before being introduced to the processing region. The precursors may enter the processing region through a dual-zone showerhead, such as the dual-zone showerhead 103 shown in Figure 1. As the atomic oxygen and silicon precursors react in the processing region, the second layer 212 is formed on the patterned first layer 204. The second layer 212 as deposited has excellent flowability, and can quickly migrate into gaps, such as gaps 210.

A post deposition anneal of the second layer 212 may be performed. In one embodiment, the second layer 212 is heated to about 300° C. to about 1000° C. (*e.g.,* about 600° C. to about 900° C.) in a substantially dry atmosphere (*e.g.,* dry nitrogen, helium, argon, etc.). The anneal removes moisture from the deposited second layer 212.

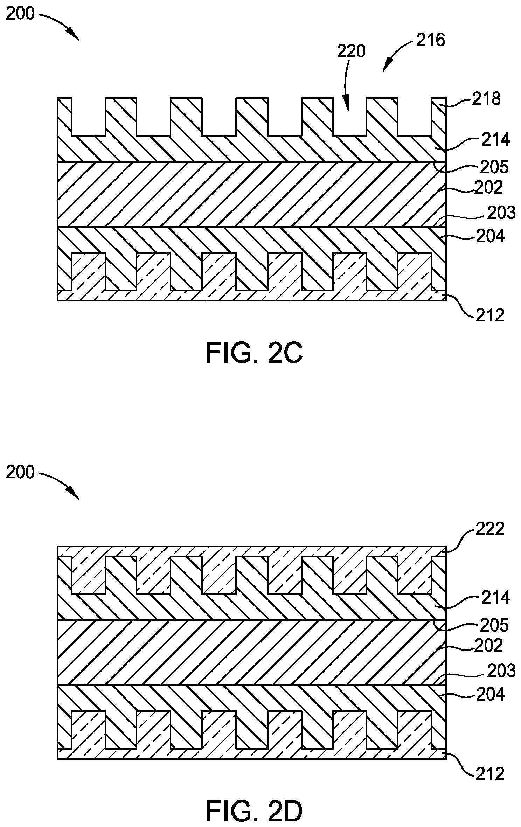

In some embodiments, both sides of the substrate 202 can be utilized to form layers having different Rls thereon. As shown in Figure 2C, a patterned third layer 214 having a third RI is formed on a second surface 205 of the substrate 202. The patterned third layer 214 has a pattern 216, and the pattern 216 includes a plurality of protrusions 218 and a plurality of gaps 220. The patterned third layer 214 may be fabricated from the same materials as the patterned first layer 204. The patterned third layer 214 may be formed by the same process as the patterned first layer 204. In one embodiment, the patterned third layer 214 is identical to the patterned first layer 204. In another embodiment, the patterned third layer 214 has a different pattern than the patterned first layer 204.

Next, as shown in Figure 2D, a fourth layer 222 is formed on the patterned third layer 214. The fourth layer 222 may be fabricated from the same materials as the second layer 212. The fourth layer 222 may be formed by the same process as the second layer 212. The optical component 200 may be used in any suitable display devices. For example, in one embodiment, the optical component 200 is used as a waveguide or waveguide combiner in augmented reality display devices. Waveguides are structures that guide optical waves. Waveguide combiners are used in augmented reality display devices that combine real world images with virtual images. In another embodiment, the optical component 200 is used as a flat lens/meta surfaces in augmented and virtual reality display devices and 3D sensing devices, such as face ID and LIDAR.

Figures 3A - 3D illustrate schematic cross-sectional views of an optical component 300 according to embodiments described herein. As shown in Figure 3A, the optical component 300 includes the substrate 202, the patterned first layer 204 disposed on the substrate 202, and the second layer 212 disposed on the patterned first layer 204. The patterned first layer 204 includes a plurality of protrusions 302. Each of the protrusions 302 has a parallelogramical cross-sectional area, as shown in Figure 3A. The protrusions 302 may be gratings.

As shown in Figure 3B, the optical component 300 includes the substrate 202, the patterned first layer 204 disposed on the substrate 202, and the second layer 212 disposed on the patterned first layer 204. The patterned first layer 204 includes a plurality of protrusions 304. Each of the protrusions 304 has a triangular cross-sectional area, as shown in Figure 3B. The protrusions 304 may be gratings.

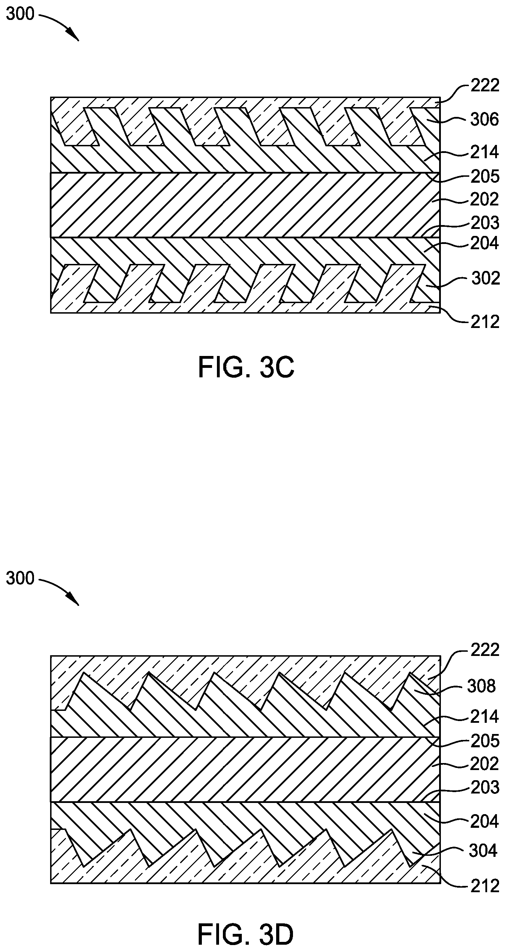

As shown in Figure 3C, the optical component 300 includes the substrate 202, the patterned first layer 204 disposed on the first surface 203 of the substrate 202, and the second layer 212 disposed on the patterned first layer 204. The patterned first layer 204 includes the plurality of protrusions 302. The optical component 300 further includes the patterned third layer 214 disposed on the second surface 205 of the substrate 202 and the fourth layer 222 disposed on the patterned third layer 214. The patterned third layer 214 includes a plurality of protrusions 306. In one embodiment, the protrusions 306 may be the same as the protrusions 302. In another embodiment, the protrusions 306 may not be the same as the protrusions 302. The protrusions 302, 306 may be gratings.

As shown in Figure 3D, the optical component 300 includes the substrate 202, the patterned first layer 204 disposed on the first surface 203 of the substrate 202, and the second layer 212 disposed on the patterned first layer 204. The patterned first layer 204 includes the plurality of protrusions 304. The optical component 300 further includes the patterned third layer 214 disposed on the second surface 205 of the substrate 202 and the fourth layer 222 disposed on the patterned third layer 214. The patterned third layer 214 includes a plurality of protrusions 308. In one embodiment, the protrusions 308 may be the same as the protrusions 304. In another embodiment, the protrusions 308 may not be the same as the protrusions 304. The protrusions 304, 308 may be gratings.

The optical component 300 may be used in any suitable display devices. For example, in one embodiment, the optical component 300 is used as a waveguide or waveguide combiner in augmented reality display devices. In another embodiment, the optical component 300 is used as a flat lens/meta surfaces in augmented and virtual reality display devices and 3D sensing devices, such as face ID and LIDAR.

A method for forming an optical component including layers having different Rls is disclosed. A patterned first layer having a higher RI is formed on a substrate, and a second layer is formed on the patterned first layer using FCVD process. The application of the optical component is not limited to augmented and virtual reality display devices and 3D sensing devices. The optical component can be used in any suitable applications.

While the foregoing is directed to embodiments of the present disclosure, other and further embodiments of the disclosure may be devised without departing from the basic scope thereof, and the scope thereof is determined by the claims that follow.

## Claims

1. A method of forming a waveguide or a flat lens, comprising:
forming a first layer (204) having a pattern (206) on a substrate, the first layer (204) having a first refractive index and comprising a metal oxide; and
forming a second layer (212) on the first layer (204) by a flowable chemical vapor deposition process at a temperature of less than 100 °C and a pressure between 0.1 Torr to 10 Torr, the second layer (212) having a second refractive index less than the first refractive index, wherein the flowable chemical vapor deposition process comprises:
generating an atomic oxygen precursor; and
introducing the atomic oxygen precursor into the processing region, wherein a silicon precursor is disposed in the processing region such that the atomic oxygen precursor and the silicon precursor are not mixed before being introduced to the processing region.

2. The method of claim 1, wherein the first refractive index ranges from about 1.7 to about 2.4.

3. The method of claim 1, wherein the first layer (204) comprises a metal oxide.

4. The method of claim 1, wherein the first layer (204) comprises titanium oxide, tantalum oxide, zirconium oxide, hafnium oxide, or niobium oxide.

5. The method of claim 1, wherein the second layer (212) comprises porous silicon dioxide or quartz.

6. The method of claim 1, wherein the second refractive index ranges from about 1.1 to about 1.5.

7. The method of claim 1, wherein
the first refractive index ranges from about 1.7 to about 2.4; and wherein
the second refractive index ranges from about 1.1 to about 1.5.

8. The method of claim 7, wherein the first layer (204) comprises titanium oxide, tantalum oxide, zirconium oxide, hafnium oxide, or niobium oxide.

9. The method of claim 7, further comprising annealing the second layer (212).

10. The method of claim 9, wherein the annealing the second layer (212) comprises heating the second layer (212) to about 300° C. to about 1000° C.

11. The method of claim 6, wherein the first layer (204) is formed on the first surface (203) of the substrate (202) by e-beam lithography or nanoimprint lithography.

12. The method of claim 6, further comprising forming a third layer (214) having a third refractive index on a second surface (205) of the substrate (202), the third layer (214) having a second pattern (216).

13. The method of claim 12, further comprising:
forming a fourth layer (222) having a fourth refractive index less than the third refractive index on the third layer (214) by the flowable chemical vapor deposition process.

14. The method of claim 13, wherein the second pattern (216) is different from the first pattern (206).

## Patentansprüche

1. Verfahren zum Ausbilden eines Wellenleiters oder einer Flachlinse, umfassend:
Ausbilden einer ersten Schicht (204) mit einem Strukturmuster (206) auf einem Substrat, wobei die erste Schicht (204) einen ersten Brechungsindex aufweist und ein Metalloxid umfasst; und
Ausbilden einer zweiten Schicht (212) auf der ersten Schicht (204) durch ein fließfähiges chemisches Gasphasenabscheidungsverfahren bei einer Temperatur von weniger als 100 °C und einem Druck zwischen 0,1 Torr und 10 Torr, wobei die zweite Schicht (212) einen zweiten Brechungsindex aufweist, der kleiner ist als der erste Brechungsindex, wobei das fließfähige chemische Gasphasenabscheidungsverfahren umfasst:
Erzeugen eines atomaren Sauerstoff-Precursor; und
Einleiten des atomaren Sauerstoff-Precursor in den Prozessbereich, wobei ein Silizium-Precursor in dem Prozessbereich so angeordnet ist, dass der atomare Sauerstoff-Precursor und der Silizium-Precursor vor dem Einleiten in den Prozessbereich nicht gemischt werden.

2. Verfahren nach Anspruch 1, wobei der erste Brechungsindex im Bereich von etwa 1,7 bis etwa 2,4 liegt.

3. Verfahren nach Anspruch 1, wobei die erste Schicht (204) ein Metalloxid umfasst.

4. Verfahren nach Anspruch 1, wobei die erste Schicht (204) Titanoxid, Tantaloxid, Zirkoniumoxid, Hafniumoxid oder Nioboxid umfasst.

5. Verfahren nach Anspruch 1, wobei die zweite Schicht (212) poröses Siliziumdioxid oder Quarz umfasst.

6. Verfahren nach Anspruch 1, wobei der zweite Brechungsindex im Bereich von etwa 1,1 bis etwa 1,5 liegt.

7. Verfahren nach Anspruch 1, wobei
der erste Brechungsindex im Bereich von etwa 1,7 bis etwa 2,4 liegt; und wobei
der zweite Brechungsindex im Bereich von etwa 1,1 bis etwa 1,5 liegt.

8. Verfahren nach Anspruch 7, wobei die erste Schicht (204) Titanoxid, Tantaloxid, Zirkoniumoxid, Hafniumoxid oder Nioboxid umfasst.

9. Verfahren nach Anspruch 7, das ferner Glühen der zweiten Schicht (212) umfasst.

10. Verfahren nach Anspruch 9, wobei das Glühen der zweiten Schicht (212) das Erwärmen der zweiten Schicht (212) auf etwa 300° C bis etwa 1000° C umfasst.

11. Verfahren nach Anspruch 6, wobei die erste Schicht (204) auf der ersten Oberfläche (203) des Substrats (202) durch Elektronenstrahl-Lithografie oder Nanoimprint-Lithografie ausgebildet wird.

12. Verfahren nach Anspruch 6, das ferner das Ausbilden einer dritten Schicht (214) mit einem dritten Brechungsindex auf einer zweiten Oberfläche (205) des Substrats (202) umfasst, wobei die dritte Schicht (214) ein zweites Strukturmuster (216) aufweist.

13. Verfahren nach Anspruch 12, ferner umfassend:
Ausbilden einer vierten Schicht (222) mit einem vierten Brechungsindex, der kleiner ist als der dritte Brechungsindex, auf der dritten Schicht (214) durch das fließfähige chemische Gasphasenabscheidungsverfahren.

14. Verfahren nach Anspruch 13, wobei das zweite Strukturmuster (216) sich von dem ersten Strukturmuster (206) unterscheidet.

## Revendications

1. Procédé de formation d'un guide d'ondes ou d'une lentille plate, consistant à:
former une première couche (204), pourvue d'un motif (206), sur un substrat, la première couche (204) ayant un premier indice de réfraction et comprenant un oxyde métallique ; et
former une deuxième couche (212) sur la première couche (204) par un procédé de dépôt chimique en phase vapeur fluide à une température inférieure à 100 °C et à une pression comprise entre 0,1 Torr et 10 Torr, la deuxième couche (212) ayant un deuxième indice de réfraction inférieur au premier indice de réfraction, le procédé de dépôt chimique en phase vapeur fluide consistant à :
générer un précurseur d'oxygène atomique ; et
introduire le précurseur d'oxygène atomique dans la zone de traitement, un précurseur de silicium étant disposé dans la zone de traitement de telle sorte que le précurseur d'oxygène atomique et le précurseur de silicium ne soient pas mélangés avant d'être introduits dans la zone de traitement.

2. Procédé selon la revendication 1,
dans lequel le premier indice de réfraction est compris entre environ 1,7 et environ 2,4.

3. Procédé selon la revendication 1,
dans lequel la première couche (204) comprend un oxyde métallique.

4. Procédé selon la revendication 1,
dans lequel la première couche (204) comprend de l'oxyde de titane, de l'oxyde de tantale, de l'oxyde de zirconium, de l'oxyde d'hafnium ou de l'oxyde de niobium.

5. Procédé selon la revendication 1,
dans lequel la deuxième couche (212) comprend du dioxyde de silicium poreux ou du quartz.

6. Procédé selon la revendication 1,
dans lequel le deuxième indice de réfraction est compris entre environ 1,1 et environ 1,5.

7. Procédé selon la revendication 1,
dans lequel le premier indice de réfraction est compris entre environ 1,7 et environ 2,4 ; et
le deuxième indice de réfraction est compris entre environ 1,1 et environ 1,5.

8. Procédé selon la revendication 7,
dans lequel la première couche (204) comprend de l'oxyde de titane, de l'oxyde de tantale, de l'oxyde de zirconium, de l'oxyde d'hafnium ou de l'oxyde de niobium.

9. Procédé selon la revendication 7,
comprenant en outre le recuit de la deuxième couche (212).

10. Procédé selon la revendication 9,
dans lequel le recuit de la deuxième couche (212) comprend le chauffage de la deuxième couche (212) à une température d'environ 300 °C à environ 1 000 °C.

11. Procédé selon la revendication 6,
dans lequel la première couche (204) est formée sur la première surface (203) du substrat (202) par lithographie par faisceau électronique ou par lithographie par nano-impression.

12. Procédé selon la revendication 6,
consistant en outre à former une troisième couche (214), ayant un troisième indice de réfraction, sur une deuxième surface (205) du substrat (202), la troisième couche (214) étant pourvue d'un deuxième motif (216).

13. Procédé selon la revendication 12,
consistant en outre à :
former une quatrième couche (222), ayant un quatrième indice de réfraction inférieur au troisième indice de réfraction, sur la troisième couche (214) par le procédé de dépôt chimique en phase vapeur fluide.

14. Procédé selon la revendication 13,
dans lequel le deuxième motif (216) est différent du premier motif (206).
